# FASCICULE DE BREVET EUROPEEN

(11) **EP 0 518 774 B1**
(45) Date de publication et mention de la délivrance du brevet: **06.03.1996**
(21) Numéro de dépôt: 92401628.0
(22) Date de dépôt: 12.06.1992
(51) Int. Cl.: C23G 5/00, C23C 16/50, H01L 21/768, H01L 21/321

(54) **Procédé de nettoyage de surfaces métalliques oxydées dans la fabrication de réseaux d'interconnexions et plaquettes pour de tels réseaux**
Verfahren zur Reinigung von oxydierten metallischen Oberflächen in der Herstellung von Verbindungsnetzwerken und Schaltungsplatten für solche Netzwerke
Process for cleaning oxidized metallic surfaces in the fabrication of interconnection networks and boards for such networks

(30) Priorité: 14.06.1991 FR 9107325
(43) Date de publication de la demande: 16.12.1992
(73) Titulaire: FRANCE TELECOM, F-75015 Paris (FR)
(72) Inventeur: Templier, François, F-38000 Grenoble (FR); Torres, Joaquim, F-38950 Saint-Martin-le-Vinoux (FR); Palleau, Jean, F-38240 Meylan (FR)
(74) Mandataire: Casalonga, Axel

(56) Documents cités:
- EP-A- 0 129 490
- EP-A- 0 300 414
- EP-A- 0 387 097
- US-A- 4 706 870
- RESEARCH DISCLOSURE, no. 309, janvier 1990; EMSWORTH, p. 82

## Description

La présente invention concerne un procédé de nettoyage de surfaces métalliques oxydées dans la fabrication des plaquettes pour réseaux d'interconnexions ainsi que les plaquettes pour de tels réseaux traitées selon ce procédé.

Dans le domaine de la fabrication des circuits intégrés, et plus particulièrement pour la fabrication de réseaux d'interconnexions multiniveaux Cu/Polyimide pour la microhybridation des circuits intégrés, on est amené à réaliser des dépôts successifs de matériaux métalliques et diélectriques.

En effet, les réseaux d'interconnexions sont réalisés de la manière suivante.

Pour la réalisation d'un premier niveau d'interconnexion, on dépose un matériau conducteur, par exemple du cuivre, puis on dépose un diélectrique qui réalise un second niveau. Le matériau diélectrique est alors recuit autour de 400°C, puis gravé en plasma sous oxygène dans les zones à métalliser pour former des trous de contact.

Durant les étapes de recuit et de gravure notamment, la surface du cuivre du premier niveau est dégradée par les traitements thermiques et chimiques subis, et les dégradations apparaissent particulièrement dans les trous de contact ou zones de futurs contacts entre le cuivre du premier niveau et le matériau conducteur, par exemple du cuivre qui est déposé, par exemple par pulvérisation cathodique, notamment dans les trous après le dépôt, recuit et gravure du diélectrique du second niveau.

La dégradation se traduit essentiellement par la formation d'oxydes CuO ou Cu₂O à la surface du cuivre du premier niveau, dans les zones du futur contact entre le cuivre de premier niveau et le cuivre déposé ultérieurement. Ces oxydes sont des isolants et leur présence augmente la résistance de contact entre les deux niveaux de cuivre. Il s'ensuit une dégradation de la propagation du signal.

Il apparaît donc primordial de préparer les surfaces avant dépôt de la seconde couche conductrice. Les méthodes de nettoyage usuellement utilisées dans le domaine de la microélectronique pour la préparation des surfaces avant dépôt, présentent certains inconvénients.

Ainsi, le nettoyage par méthode physique consiste à pulvériser la surface à nettoyer par plasma neutre. Cependant, pour des surfaces présentant des motifs, le plasma agit non seulement sur les motifs, comme des surfaces en cuivre pour des lignes conductrices par exemple, mais aussi sur toutes les surfaces situées entre les surfaces métalliques, si bien que l'on constate une repulvérisation du diélectrique sur les surfaces métalliques. Ainsi, dans le cas des surfaces de contact entre deux couches de cuivre séparées par une couche de diélectrique tel que décrit ci-dessus, la pulvérisation conduit toujours à redéposer sur la surface de cuivre une partie du matériau isolant situé sur les parties adjacentes du trou de contact.

Par ailleurs, la méthode de gravure dite RIE (Reactive Ionic Etching) nécessite l'utilisation d'un masque de gravure, la gravure n'étant réalisée que sur des parties choisies de la surface. L'utilisation d'un masque de gravure rend cette étape coûteuse. De plus, le masque peut être lui-même gravé et de ce fait, des résidus organiques peuvent être apportés sur la surface métallique à nettoyer. Enfin, ce procédé de gravure induit une consommation du matériau métallique, ce qui rend cette technique particulièrement délicate à utiliser dans la fabrication des interconnexions minces, la consommation du matériau métallique étant dans ce cas à minimiser.

Enfin, le nettoyage par attaque chimique en phase liquide ou vapeur, c'est-à-dire la gravure chimique, activée dans le cas de la gravure assistée par ultraviolets, ou non activée, dans le cas de la gravure liquide, remédie à l'inconvénient de l'utilisation du masque intermédiaire car elle ne peut agir que sur les zones à traiter si l'on fait un choix adéquat de réactifs. Elle conduit néanmoins toujours à une consommation du matériel conducteur.

La présente invention remédie aux inconvénients décrits ci-dessus.

Ainsi, la présente invention concerne un procédé de nettoyage des surfaces métalliques oxydées mis en oeuvre dans la fabrication des plaquettes pour réseaux d'interconnexions comportant au moins :
- une première couche conductrice métallisée,
- une couche diélectrique déposée sur la couche métallisée, puis gravée pour dénuder des surfaces à métalliser ou trous de contact, et
- une seconde couche métallisée déposée sur la surface gravée,
   caractérisé en ce que les plaquettes gravées sont traitées par plasma multipolaire micro-onde sous hydrogène avant le dépôt de la seconde couche métallisée.

Par le procédé selon l'invention, il est possible de supprimer les oxydes de la surface à métalliser, et ainsi de la nettoyer sans consommation du matériau conducteur ni utilisation de masque intermédiaire ni repulvérisation du diélectrique sur les surfaces à métalliser. Le nettoyage de la surface métallique à métalliser, réalisé par plasma multipolaire micro-onde sous hydrogène (PMM hydrogène), est ainsi opéré de manière sélective et sans perte du matériau conducteur.

Pour mettre en oeuvre le procédé de nettoyage de l'invention, on peut utiliser un dispositif usuel à plasma de décharge multipolaire micro-onde.

De tels dispositifs ont notamment été décrits dans J. Phys. D 19, 795 (1986) et dans Rev. Sci. Instr. 59, 1072 (1988) ainsi que dans le brevet US 4 745 337.

La décharge de type PMM confère aux ions créés une énergie très faible, de l'ordre de l'électron-volt, et permet d'activer, par formation d'espèces plus actives comme des ions ou des radicaux, la réduction des oxydes métalliques par l'hydrogène et de régénérer la couche métallisée.

Pour les couches conductrices métallisées, on peut utiliser le cuivre et on peut envisager d'autres matériaux comme le nickel et le tungstène.

Dans le cas du cuivre, par le procédé selon l'invention, on peut réduire l'oxyde de cuivre par l'hydrogène et régénérer le cuivre à température ambiante.

Le procédé peut cependant être mis en oeuvre à d'autres températures, notamment dans le cas d'autres métaux où une activation thermique peut être souhaitable ou nécessaire. Les températures d'activation peuvent varier entre 0°C et des températures de l'ordre de 400°C. Ainsi, dans le cas du tungstène, une activation thermique à des températures pouvant aller de 300 à 400°C est souhaitable pour activer la cinétique de réduction de ce métal.

Le procédé de l'invention peut également être mis en oeuvre avec des matériaux où une polarisation du substrat est nécessaire. La tension de cette polarisation en tension continue ou en tension haute fréquence, peut varier entre 0 et 1000 volts.

Le procédé selon l'invention peut être mis en oeuvre à des pressions allant d'environ 1,33310⁻ Pa à 13,33 Pa, de préférence environ 1,33310⁻ Pa.

Comme diélectrique, on peut utiliser des diélectriques organiques ou non-organiques usuels, que l'on choisis selon la structure du réseau à fabriquer.

Pour la mise en oeuvre de l'invention, on peut utiliser en particulier des diélectriques polymères, et de préférence des diélectriques de type polyimide.

Dans une variante du procédé selon l'invention, l'étape de nettoyage est réalisée dans le sas d'introduction de l'enceinte de dépôt de la seconde couche métalisée. Dans cette variante, le plasma PMM est créé dans ce sas, ce qui permet de réaliser le nettoyage in-situ avant le dépôt de la seconde couche métallisée. On peut ainsi prévoir un système de chargement permettant de transférer les plaquettes nettoyées du sas d'introduction de l'enceinte de dépôt où a lieu le nettoyage par PMM hydrogène dans l'enceinte de dépôt du cuivre par pulvérisation cathodique sans casser le vide. Toute reconstitution d'une couche d'oxyde à la surface du cuivre de la première couche conductrice métallisée peut être alors évitée. De plus, comme le gaz utilisé est non polluant, la régénération des surfaces métalliques peut être réalisée, comme prévu ci-dessus dans le sas d'introduction de la machine de dépôt, sans risque de pollution de cette machine par un gaz réactif d'utilisation critique.

Par ailleurs, le traitement par plasma multipolaire micro-onde permet la gravure de résidus organiques qui se trouveraient à la surface du cuivre de la première couche et résultant d'étapes antérieures.

Dans une variante du procédé selon l'invention, on peut donc prévoir, avant le nettoyage de la surface métallique par réduction par PMM sous hydrogène, une étape de gravure par PMM sous oxygène des résidus organiques sur la surface métallisée; la surface métallisée oxydée est alors nettoyée et régénérée par PMM sous hydrogène. Le dépôt de la couche métallique supérieure peut alors être effectué et il résulte de la mise en oeuvre du procédé selon l'invention, une résistance métal/métal minimisée.

Les plaquettes pour réseaux d'interconnexions comportant au moins une première couche conductrice métallisée, une couche de diélectrique déposée sur la couche métallisée puis gravée pour dénuder des surfaces à métalliser ou trous de contact, et une seconde couche métallisée déposée sur la surface gravée, dans lesquelles les surfaces à métalliser ont été traitées par plasma multipolaire micro-onde sous hydrogène avant le dépôt de la seconde couche métallisée selon le procédé de l'invention, présentent des résistances de contact entre les niveaux métallisés minimisées.

A titre d'exemple, on a réalisé la régénération de couches de cuivre.

Des couches de cuivre de 100 nm ont été oxydées à 400°. Il en résulte des couches d'oxyde de 170 nm.

Après traitement des couches d'oxyde au plasma multipolaire micro-onde sous hydrogène, la couche de cuivre est régénérée avec conservation de la quantité initiale de cuivre (100 nm). La vitesse de régénération du cuivre est de l'ordre de 6 nm/mn.

## Revendications

1. Procédé de nettoyage de surfaces métallisées oxydées mises en oeuvre dans la fabrication des plaquettes pour réseaux d'interconnexions, comportant au moins :
- une première couche conductrice métallisée,
- une couche diélectrique déposée sur la couche métallisée, puis gravée pour dénuder les surfaces à métalliser ou trous de contact, et
- une seconde couche métallisée déposée sur la surface gravée,
caractérisé en ce que les plaquettes gravées sont traitées par plasma multipolaire micro-onde sous hydrogène avant le dépôt de la seconde couche métallisée.

2. Procédé selon la revendication 1, caractérisé en ce que la première couche conductrice métallisée et/ou la seconde couche conductrice métallisée est ou sont constituée(s) essentiellement de cuivre, de nickel ou de tungstène.

3. Procédé selon la revendication 1 ou 2, caractérisé en ce que la première couche conductrice métallisée et/ou la seconde couche conductrice métallisée est ou sont constituée(s) essentiellement de cuivre.

4. Procédé selon l'une des revendications 1 à 3, caractérisé en ce que le traitement par plasma multipolaire micro-onde est réalisé à une température comprise entre 0°C et 400°C.

5. Procédé selon l'une des revendications 1 à 4, caractérisé en ce que le traitement par plasma multipolaire micro-onde sous hydrogène est réalisé à température ambiante.

6. Procédé selon l'une des revendications 1 à 5, caractérisé en ce que le traitement par plasma multipolaire micro-onde est assisté par polarisation du substrat, la tension de polarisation variant de 0 à 1000 volts.

7. Procédé selon l'une des revendications 1 à 6, caractérisé en ce que le traitement par plasma multipolaire micro-onde sous hydrogène est réalisé dans la même enceinte que le dépôt.

8. Procédé selon l'une des revendications 1 à 7, caractérisé en ce que le traitement par plasma multipolaire micro-onde sous hydrogène est directement précédé par un traitement de gravure par plasma multipolaire micro-onde sous oxygène.

## Patentansprüche

1. Verfahren zur Reinigung metallisierter oxidierter Oberflächen zur Anwendung bei der Herstellung von Platten für Schaltungsnetze, die mindestens:
- eine erste leitfähige metallisierte Schicht,
- eine dielektrische Schicht, die auf der metallisierten Schicht abgeschieden und dann geätzt wird, um die zu metallisierenden Oberflächen oder Kontaktlöcher freizulegen, sowie
- eine zweite metallisierte Schicht, die auf der geätzten Oberfläche abgeschieden wird,
aufweisen,
dadurch **gekennzeichnet**, daß
die geätzten Platten mit einem multipolaren Mikrowellen-Plasma unter Wasserstoff vor der Abscheidung der zweiten metallisierten Schicht behandelt werden.

2. Verfahren gemäß Anspruch 1,
dadurch **gekennzeichnet**, daß
die erste und/oder zweite leitfähige metallisierte Schicht im wesentlichen aus Kupfer, Nickel oder Wolfram sind.

3. Verfahren gemäß Anspruch 1 oder 2,
dadurch **gekennzeichnet**, daß
die erste und/oder zweite leitfähige metallisierte Schicht im wesentlichen aus Kupfer sind.

4. Verfahren gemäß einem der Ansprüche 1 bis 3,
dadurch **gekennzeichnet**, daß
die Behandlung mit dem multipolaren Mikrowellen-Plasma bei einer Temperatur von 0 bis 400°C durchgeführt wird.

5. Verfahren gemäß einem der Ansprüche 1 bis 4,
dadurch **gekennzeichnet**, daß
die unter einer Wasserstoff-Atmosphäre erfolgende Behandlung mit dem multipolaren Mikrowellen-Plasma bei Umgebungstemperatur durchgeführt wird.

6. Verfahren gemäß einem der Ansprüche 1 bis 5,
dadurch **gekennzeichnet**, daß
die Behandlung mit dem multipolaren Mikrowellen-Plasma durch Polarisation des Substrats unterstützt wird, wobei die Polarisationsspannung 0 bis 1000 Volt beträgt.

7. Verfahren gemäß einem der Ansprüche 1 bis 6,
dadurch **gekennzeichnet**, daß
die unter einer Wasserstoff-Atmosphäre erfolgende Behandlung mit dem multipolaren Mikrowellen-Plasma in derselben Einfassung wie die Abscheidung durchgeführt wird.

8. Verfahren gemäß einem der Ansprüche 1 bis 7,
dadurch **gekennzeichnet**, daß
unmittelbar vor der unter Wasserstoff durchgeführten Behandlung mit dem multipolaren Mikrowellen-Plasma eine unter Sauerstoff durchzuführende Ätzungsbehandlung mit einem multipolaren Mikrowellen-Plasma erfolgt.

## Claims

1. A process for cleaning oxidized metallized surfaces, employed in the manufacture of wafers for interconnection networks, comprising at least:
- a first metallized conducting layer,
- a dielectric layer deposited on the metallized layer and then etched in order to bare the surfaces to be metallized or contact holes, and
- a second metallized layer deposited on the etched surface,
wherein the etched wafers are treated using microwave multipolar plasma under hydrogen before the deposition of the second metallized layer.

2. The process as claimed in claim 1, wherein the first metallized conducting layer and/or the second metallized conducting layer essentially consists or consist of copper, nickel or tungsten.

3. The process as claimed in claim 1 or 2, wherein the first metallized conducting layer and/or the second metallized conducting layer essentially consists or consist of copper.

4. The process as claimed in one of claims 1 to 3, wherein the treatment using microwave multipolar plasma is carried out at a temperature lying between 0°C and 400°C.

5. The process as claimed in one of claims 1 to 4, wherein the treatment using microwave multipolar plasma under hydrogen is carried out at ambient temperature.

6. The process as claimed in one of claims 1 to 5, wherein the treatment using microwave multipolar plasma is assisted by bias of the substrate, the bias voltage varying from 0 to 1000 volts.

7. The process as claimed in one of claims 1 to 6, wherein the treatment using microwave multipolar plasma under hydrogen is carried out in the same chamber as the deposition.

8. The process as claimed in one of claims 1 to 7, wherein the treatment using microwave multipolar plasma under hydrogen is directly preceded by an etching treatment using microwave multipolar plasma under oxygen.
